# EUROPEAN PATENT APPLICATION

(11) **EP 4 553 197 A1**
(43) Date of publication of application: **14.05.2025**
(21) Application number: 23839011.6
(22) Date of filing: 13.07.2023
(51) Int. Cl.: C30B 11/00, C30B 30/00, C30B 29/40

(54) **DEVICE AND METHOD FOR SYNTHESIZING INDIUM PHOSPHIDE AND PREPARING VGF CRYSTAL**

(30) Priority: 15.07.2022 CN 202210829113
(71) Applicant: The 13th Research Institute Of China Electronics Technology Group Corporation, Shijiazhuang, Hebei 050051 (CN)
(72) Inventor: WANG, Shujie, Shijiazhuang, Hebei 050051 (CN); SUN, Niefeng, Shijiazhuang, Hebei 050051 (CN); SHI, Yanlei, Shijiazhuang, Hebei 050051 (CN); LIU, Zheng, Shijiazhuang, Hebei 050051 (CN); SHAO, Huimin, Shijiazhuang, Hebei 050051 (CN); DANG, Jiping, Shijiazhuang, Hebei 050051 (CN); XU, Senfeng, Shijiazhuang, Hebei 050051 (CN); JIANG, Jian, Shijiazhuang, Hebei 050051 (CN); LI, Xiaolan, Shijiazhuang, Hebei 050051 (CN); WANG, Yang, Shijiazhuang, Hebei 050051 (CN); ZHANG, Xiaodan, Shijiazhuang, Hebei 050051 (CN); LIU, Huisheng, Shijiazhuang, Hebei 050051 (CN)
(74) Representative: Sun, Yiming
(86) International application number: PCT/CN2023/107178
(87) International publication number: WO 2024/012521

(57) **Abstract**

Provided are a device and method for indium phosphide synthesis and VGF crystal preparation. Firstly, indium is placed in a crucible, and phosphorus is placed in a center of an auxiliary crucible area; the crucible is then heated, and a centrifugal force is applied thereto; and under the action of a centrifugal force, an indium melt surrounds a main crucible area to form a barrel shape, and the indium and phosphorus are in a surface-contact separation state. By means of multi-temperature-zone heating, indium and phosphorus are heated to different temperatures, and a volatile element phosphorus sublimes and is then combined with a metal element indium. After synthesis is finished, a rotation speed of the crucible is reduced, a synthesized melt is in a horizontal state, and boron oxide is introduced therein to realize crystal growth.

## Description

### TECHNICAL FIELD

The present invention relates to preparation of compound semiconductors, and in particular to a device and method for indium phosphide synthesis and crystal preparation using a centrifugal device.

### BACKGROUND

Main methods for synthesis of compounds of volatile materials and metals include: a synthesis solute diffusion (SSD) method, a horizontal Bridgman (HB) method/a horizontal gradient freeze (HGF) method, and an injection synthesis method. The injection synthesis method is most efficient and is used to achieve low-cost industrialization of high-quality polycrystalline. For example, all the patents 202010487276.2, 202110618242.7, 202110618255.4, 202110376836.1 and the like disclose technical solutions for synthesizing compound semiconductor materials using gas injection devices: a heating injection device is used for heating and vaporizing a volatile gas source material, and then vaporized elements are injected into a melt through an injection pipe to complete synthesis. However, the above solutions have a hidden defect of melt backflow.

In order to solve the above problems, the patent 202110760674.1 discloses a solution of placing a volatile material in a melt and vaporizing the volatile material at a temperature of the melt, but has the defects such as uneven diffusion of the volatile material in the melt and waste caused by overflowing of the melt.

### SUMMARY

In order to solve the problems existing in the prior art, the present invention is provided.

The present invention adopts a technical solution as follows: a device for indium phosphide synthesis and VGF crystal preparation, including a furnace body, a crucible in the furnace body, a multi-section heater on a periphery of the crucible, a thermal insulation sleeve, a crucible support, and a main support, where key points of the present invention lie in: the device further includes a centrifugal motor connected to the main support, and the centrifugal motor drives the main support, the crucible support and the crucible to rotate.

The crucible is provided with a crucible cover at a top end, and a sealing groove is formed on an upper portion of the crucible cover.

The device further includes a sealing cover that fits the sealing groove, and the sealing cover is connected to a sealing cover driving device outside the furnace body through an auxiliary rod I; a volatile element loader is connected below the sealing cover, the volatile element loader is provided with ventilation holes, and the sealing cover, under the action of the driving device, extends the volatile element loader into and out of the crucible.

The device further includes an auxiliary feeder arranged inside the furnace body, and the auxiliary feeder is connected to an auxiliary feeder driving device outside the furnace body through an auxiliary rod II.

Further, the ventilation holes are formed around the volatile element loader.

Further, the crucible includes a main crucible, an auxiliary crucible and a seed crystal tank, with diameters decreasing sequentially.

Further, the device further includes a thermocouple hole I, a thermocouple hole II, a thermocouple hole III, a thermocouple hole IV, and a central thermocouple hole.

Based on the above device, the present invention further provides a method for indium phosphide synthesis and VGF crystal preparation, and the method includes the following steps:
S1, placing a seed crystal in the seed crystal tank, and placing metal indium in the main crucible; placing boron oxide in the auxiliary feeder; placing red phosphorus in the volatile element loader; and separating a second thermocouple and a third thermocouple from the thermocouple hole II and the thermocouple hole III;
   the metal indium is in a cylindrical shape, an inner diameter thereof is larger than a diameter of the volatile element loader, and an outer diameter thereof is larger than a maximum diameter of the auxiliary crucible; and
   putting a sealing material into the sealing groove; and welding the crucible cover to the crucible for integration.
S2, evacuating the furnace body to 100 Pa-10-5 Pa.
S3, heating the sealing material in the sealing groove through the multi-section heater until melting, placing the volatile element loader into the auxiliary crucible through the auxiliary rod I, and placing the sealing cover on the sealing groove simultaneously, to separate the auxiliary rod I from the sealing cover; and adjusting the multi-section heater to cool down and solidify the sealing material, and sealing the crucible by using the solidified sealing material and the sealing cover.
S4, starting the centrifugal motor to drive the main support, the crucible support and the crucible to rotate at a speed of 500-5000 rpm.
S5, heating the main crucible to 30-200°C above a melting point of indium phosphide using the multi-section heater; and simultaneously heating the auxiliary crucible to 590°C, gradually increasing the temperature to 650°C, and during the heating process, gradually introducing inert gas into the furnace body until reaching 12.75 MPa; and
   during this process, the red phosphorus is heated and sublimates into a gas, and the gas is in contact with a large area of an indium melt for synthesis.
S6, after 3-5 h of synthesis, adjusting power of each section of the multi-section heater, wherein temperatures of a first thermocouple (7) and a fourth thermocouple drop to 550°C, such that synthesized indium phosphide is solidified into a cylindrical solid, and a temperature of the auxiliary crucible drops to below 590°C; and gradually reducing the pressure inside the furnace body to one atmospheric pressure;
   reducing a rotational speed of the centrifugal motor to 0; and
   adjusting the power of the multi-section heater close to a heater in the sealing groove to melt the sealing material; and connecting the auxiliary rod I and the sealing cover, such that the volatile element loader is detached from inside of the crucible and the sealing cover is away from the crucible.
S7, pouring the boron oxide in the auxiliary feeder into the crucible through the auxiliary rod II;
   inserting the second thermocouple and the third thermocouple into the thermocouple hole II and the thermocouple hole III respectively;
   adjusting the power of each section of the multi-section heater, such that the temperature of the central thermocouple is 20-50°C below the melting point of indium phosphide, the temperatures of the first thermocouple, the second thermocouple, the third thermocouple, the fourth thermocouple are 50-200°C above the melting point of indium phosphide, an indium phosphide melt in the crucible has a temperature gradient of 5-50 cm/°C, and the temperature in a direction close to the seed crystal is low; and
   the cylindrical solid indium phosphide melts into liquid again and flows into the main crucible and the auxiliary crucible. Since the temperature at a bottom of the seed crystal is lower than the melting point of indium phosphide, the temperature of synthesized indium phosphide melt is higher than that of indium phosphide; part of the seed crystal melts, and an equilibrium state between the seed crystal and the indium phosphide melt is established.
S8, adjusting the power of each section of the multi-section heater to establish a vertical temperature gradient and achieve single crystal growth of indium phosphide; and after the growth is completed, cooling the system to room temperature, removing the crucible from the crucible support, and taking out a crystal.

In the present invention, firstly, indium is placed in a crucible, and phosphorus is placed in a center of an auxiliary crucible area; the crucible is then heated, and a centrifugal force is applied thereto; and under the action of a centrifugal force, an indium melt surrounds a main crucible area to form a barrel shape, and the indium and phosphorus are in a surface-contact separation state. By means of multi-temperature-zone heating, indium and phosphorus are heated to different temperatures, and a volatile element phosphorus sublimes and is then combined with a metal element indium. After synthesis is finished, a rotation speed of the crucible is reduced, a synthesized melt is in a horizontal state, and boron oxide is introduced therein to realize crystal growth.

Beneficial effects: the device and method provided by the present invention are used, and a phosphorus element injection device is not provided with a heater, which simplifies a synthesis device and eliminates hidden dangers such as melt backflow to the injection device and bursting of the injection device; indium is in a cylindrical shape, close to a side wall of the crucible, and closer to a main heater, thereby having higher heating efficiency; a segmented heater heats indium and phosphorus elements respectively, without mutual interference; during the fast synthesis, a contact area between an indium solution and phosphorus gas is large, such that all phosphorus elements are involved in the synthesis, thereby eliminating loss and waste; all materials are loaded before a compound is generated, such that external contamination is reduced; and further technical means can achieve in-situ growth of crystals and improve efficiency.

### BRIEF DESCRIPTION OF THE DRAWINGS

FIG. 1 is a schematic diagram of a device after loading materials.
FIG. 2 is a schematic diagram of a device during synthesis.
FIG. 3 is a schematic diagram of a device after synthesis.
FIG. 4 is a schematic diagram of a device with crystal growth.
FIG. 5 is a schematic diagram of a crucible.

Reference numerals in the figures: 1: crucible; 1-1: crucible cover; 1-2: sealing groove; 1-3: main crucible; 1-4: auxiliary crucible; 1-5: seed crystal tank; 2: multi-section heater; 3: thermal insulation sleeve; 4: crucible support; 4-1: thermocouple hole I; 4-2: thermocouple hole II; 4-3: thermocouple hole III; 4-4: thermocouple hole IV; 4-5: central thermocouple hole; 5: indium; 6: seed crystal; 7: first thermocouple; 8: second thermocouple; 9: third thermocouple; 10: fourth thermocouple; 11: main support; 12: central thermocouple ;13: sealing material; 14: centrifugal motor; 15: auxiliary rod I; 16: volatile element loader; 16-1: ventilation hole; 17: auxiliary rod II; 17-1: auxiliary feeder; 18: sealing cover 19: red phosphorus; 20: crystal; 21: boron oxide; and 22: furnace body.

### DETAILED DESCRIPTION OF EMBODIMENTS

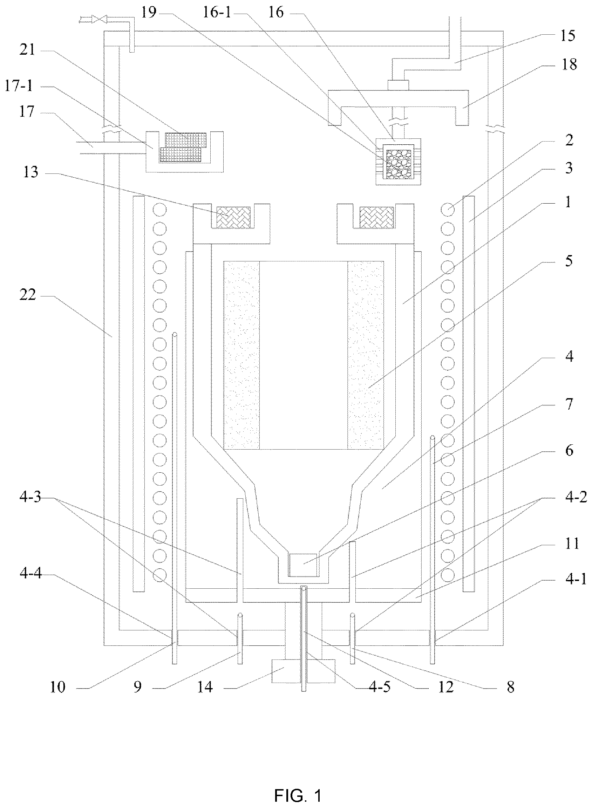

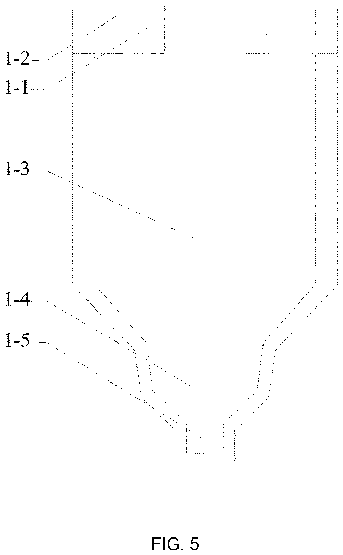

With reference to FIGs. 1 and 5, a device for indium phosphide synthesis and VGF crystal preparation includes a furnace body 22, a crucible 1 in the furnace body 22, a multi-section heater 2 on a periphery of the crucible 1, a thermal insulation sleeve 3, a crucible support 4, and a main support 11, where the furnace body 22 is in a sealed state during operation, and is provided with inflating/deflating holes for pressurization and depressurization.

The device further includes a centrifugal motor 14 connected to the main support 11, and the centrifugal motor 14 drives the main support 11, the crucible support 4 and the crucible 1 to rotate.

The crucible 1 is provided with an opening on an upper surface, and a crucible cover 1-1 at a top end, and a sealing groove 1-2 is formed on an upper portion of the crucible cover 1-1.

An internal space of crucible 1 includes a main crucible 1-3, an auxiliary crucible 1-4 and a seed crystal tank 1-5, with diameters decreasing sequentially. The auxiliary crucible 1-4 is horn-shaped with a large section and a small section from top to bottom.

The main crucible 1-3 is used for indium material distribution and indium phosphide synthesis in a synthesis stage, and the auxiliary crucible 1-4 is used for phosphorus material volatilization in the synthesis stage.

The device further includes a sealing cover 18 that fits the sealing groove 1-2, and the sealing cover 18 is connected to a sealing cover driving device outside the furnace body 22 through an auxiliary rod I15; a volatile element loader 16 is connected below the sealing cover 18, the volatile element loader 16 is provided with ventilation holes 16-1, and the sealing cover 18, under the action of the driving device, extends the volatile element loader 16 into and out of the crucible 1; and the ventilation holes 16-1 are formed around the volatile element loader 16.

The device further includes an auxiliary feeder 17-1 arranged inside the furnace body 22, and the auxiliary feeder 17-1 is connected to an auxiliary feeder driving device outside the furnace body 22 through an auxiliary rod II17.

The device further includes a thermocouple hole I4-1, a thermocouple hole II4-2, a thermocouple hole III4-3, a thermocouple hole IV4-4, and a central thermocouple hole 4-5 for placing a first thermocouple 7, a second thermocouple 8, a third thermocouple 9, a fourth thermocouple 10 and a central thermocouple 12.

The thermocouple hole I4-1 penetrates through the furnace body 22, and a top thereof is close to a lower end of the main crucible 1-3; the thermocouple hole IV4-4 penetrates through the furnace body 22, and a top thereof is in a middle of the main crucible 1-3; the thermocouple hole II4-2 penetrates through the furnace body 22, the main support 11, and the crucible support 4, and a top thereof is in a middle of the auxiliary crucible 1-4; the thermocouple hole III4-3 penetrates through the furnace body 22, the main support 11, and the crucible support 4, and a top thereof is at an upper end of the auxiliary crucible 1-4; and the central thermocouple hole 4-5 penetrates through the furnace body 22, the main support 11, and the crucible support 4, and a top thereof is at a bottom of the seed crystal tank 1-5.

The above is an example of the device for indium phosphide synthesis and VGF crystal preparation.

Based on the above example, the present invention further provides an example of a method for indium phosphide synthesis and VGF crystal preparation, and the method involves stages of preparation, indium phosphide synthesis, and VGF crystal growth, with details as follows.

### Preparation stage:

S1, place a seed crystal 6 in the seed crystal tank 1-5, and place metal indium 5 in the main crucible 1-3; place boron oxide 21 in the auxiliary feeder 17-1; place red phosphorus 19 in the volatile element loader 16; and separate the second thermocouple 8 and the third thermocouple 9 from the thermocouple hole II4-2 and the thermocouple hole III4-3 to avoid any accident when the crucible 1 rotates.

The metal indium 5 is prepared in a cylindrical shape, and an inner diameter thereof is larger than a diameter of the volatile element loader 16, such that the volatile element loader 16 can pass through and enter the auxiliary crucible 1-4; and an outer diameter thereof is larger than a maximum diameter of the auxiliary crucible 1-4, such that the metal indium 5 is placed in the main crucible 1-3 and will not enter the auxiliary crucible 1-4.

Put a sealing material 13 into the sealing groove 1-2; and weld the crucible cover 1-1 to the crucible 1 for integration, and place same on the crucible support 4.

The sealing material 13 is an alloy material or an oxide material with a melting point of 800-1300°C, or a sealing material made of indium phosphide.

Seal the furnace body 22.

Insert the first thermocouple 7 into the thermocouple hole I4-1, insert the fourth thermocouple 10 into the thermocouple hole IV4-4, and insert the central thermocouple 12 is inserted into the central thermocouple hole 4-5.

A state of the device in this case is shown in FIG. 1.

### Stage of indium phosphide synthesis:

S2, evacuate the furnace body 22 to 100 Pa-10-5 Pa.

S3, heat the sealing material 13 in the sealing groove 1-2 through the multi-section heater 2 until melting, place the volatile element loader 16 into the auxiliary crucible 1-4 through the auxiliary rod I15, and place the sealing cover 18 on the sealing groove 1-2 simultaneously, to separate the auxiliary rod I15 from the sealing cover 18; and adjust the multi-section heater 2 to cool down and solidify the sealing material 13, and seal the crucible 1 by using the solidified sealing material 13 and the sealing cover 18.

The auxiliary rod I15 and the sealing cover 18 can be connected and separated by means of a manipulator.

Since the metal indium 5 is hollow and has a diameter larger than the diameter of the volatile element loader 16, such that the volatile element loader 16 can pass through and enter the auxiliary crucible 1-4.

The crucible 1 is sealed by using the solidified sealing material 13 and the sealing cover 18, thereby ensuring that the crucible 1, the sealing cover 18, and the volatile element loader 16 rotate simultaneously in the following steps.

S4, start the centrifugal motor 14 to drive the main support 11, the crucible support 4 and the crucible 1 to rotate at a speed of 500-5000 rpm.

S5, heat the main crucible 1-3 to 30-200°C above a melting point of indium phosphide using the multi-section heater 2; and simultaneously heat the auxiliary crucible 1-4 to 590°C, gradually increase the temperature to 650°C, and during the heating process, gradually introduce inert gas into the furnace body 22 until reaching 12.75 MPa, where during this process, the red phosphorus 19 is heated and sublimates into a gas, and the gas is in contact with a large area of an indium melt for synthesis.

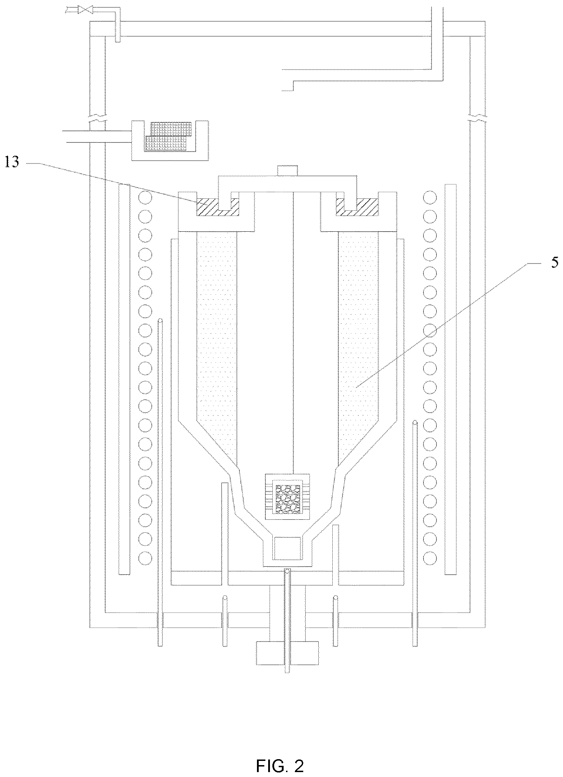

A state of the device in this case is shown in FIG. 2.

After the indium phosphide 5-1 is melted, the indium melt is fitted onto a wall of the main crucible 1-3 under the action of a centrifugal force. Since the auxiliary crucible 1-4 is horn-shaped with the large section and the small section from top to bottom, the indium melt will not flow into the auxiliary crucible 1-4.

A triple point of phosphorus is about 590°C, and when the temperature is above the triple point, phosphorus can sublimate in a relatively faster manner.

After the phosphorus in the crucible 1-4 is vaporized, an internal pressure of the crucible 1 increases. In order to balance internal and external pressures of the crucible 1 and prevent the crucible 1 from being damaged due to an imbalance in the internal and external pressures, the furnace body 22 is gradually inflated with inert gas during the heating process.

A relationship between a temperature in the auxiliary crucible 1-4 and a pressure of the inert gas inflated is:
Log₁₀^{P}=-6070/T+8.67, where P is the pressure (atm, latm=101325Pa), and T is a thermodynamic temperature in the auxiliary crucible 1-4.

When the auxiliary crucible 1-4 is heated to 650°C, the internal pressure is approximately 12.75 MPa.

S6, after 3-5 h of synthesis, adjust power of each section of the multi-section heater 2, where the temperatures of the first thermocouple 7 and the fourth thermocouple 10 drop to 550°C, such that the synthesized indium phosphide is solidified into a cylindrical solid, and the temperature of the auxiliary crucible 1-4 drops to below 590°C; and gradually reduce the pressure inside the furnace body 22 to one atmospheric pressure.

Reduce a rotational speed of the centrifugal motor 14 to 0.

When the temperature inside the auxiliary crucible 1-4 drops to below 590°C and any remaining red phosphorus no longer volatilizes, there is very little gas inside the auxiliary crucible 1-4.

Adjust the power of the multi-section heater 2 close to a heater in the sealing groove 1-2 to melt the sealing material 13; and connect the auxiliary rod I15 and the sealing cover 18, such that the volatile element loader 16 is detached from inside of the crucible 1 and the sealing cover 18 is away from the crucible 1.

During the above process, when the sealing cover 18 cannot be moved due to the imbalance in the internal and external pressures of the auxiliary crucible 1-4, gas will be extracted from the furnace body 22 to reduce the internal pressure until the volatile element loader 16 is detached from the inside of the crucible 1 and the sealing cover 18 is away from the crucible 1.

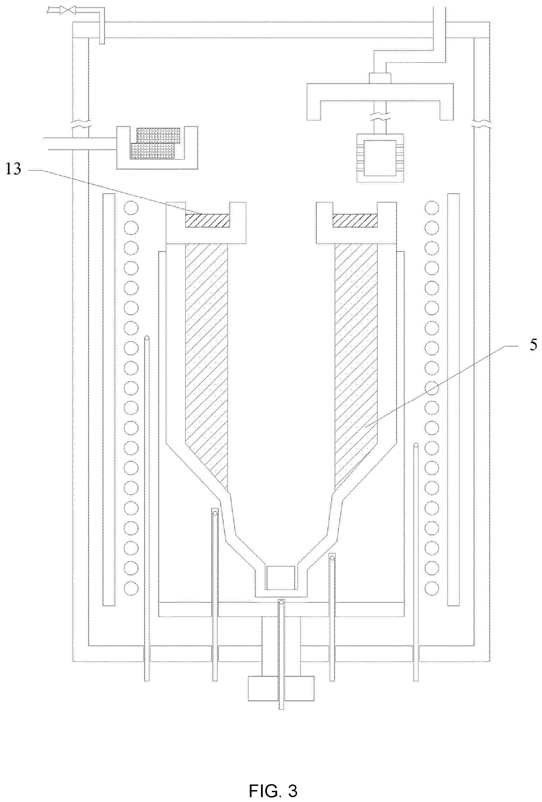

A state of the device in this case is shown in FIG. 3.

### Stage of crystal growth:

S7, pour the boron oxide 21 in the auxiliary feeder 17-1 into the crucible 1 through the auxiliary rod II17; and insert the second thermocouple 8 and the third thermocouple 9 into the thermocouple hole II4-2 and the thermocouple hole III4-3 respectively.

Adjust the power of each section of the multi-section heater 2, such that the temperature of the central thermocouple 12 is 20-50°C below the melting point of indium phosphide, the temperatures of the first thermocouple 7, the second thermocouple 8, the third thermocouple 9, the fourth thermocouple 10 are 50-200°C above the melting point of indium phosphide, an indium phosphide melt in the crucible 1 has a temperature gradient of 5-50 cm/°C, and the temperature in a direction close to the seed crystal 6 is low.

The cylindrical solid indium phosphide melts into liquid again and flows into the main crucible 1-3 and the auxiliary crucible 1-4. Since the temperature at the bottom of the seed crystal 6 is lower than the melting point of indium phosphide, the temperature of synthesized indium phosphide melt is higher than that of indium phosphide. Part of the seed crystal 6 melts, and an equilibrium state between the seed crystal 6 and the indium phosphide melt is established.

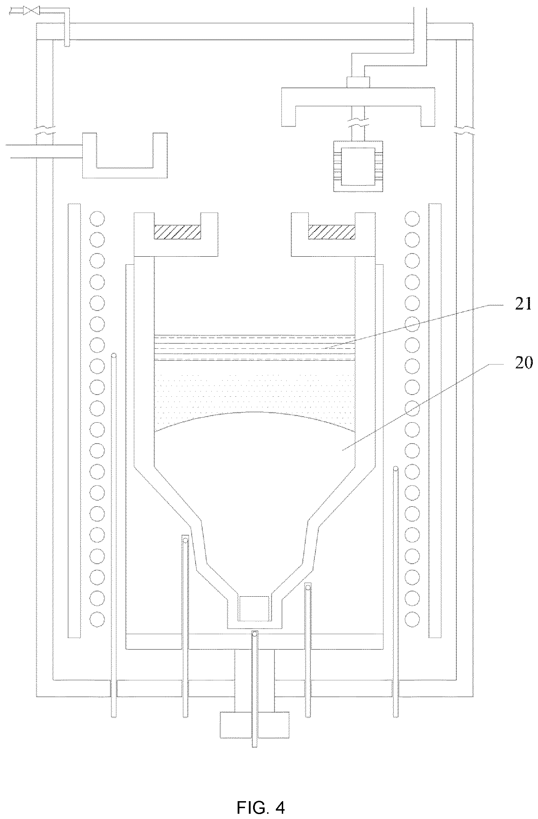

S8, adjust the power of each section of the multi-section heater 2 to establish a vertical temperature gradient and achieve single crystal growth of indium phosphide. Refer to FIG. 4 for details.
After the growth is completed, cool the system to room temperature, remove the crucible 1 from the crucible support 4, and take out a crystal 20.

## Claims

1. A device for indium phosphide synthesis and VGF crystal preparation, **characterized by** comprising a furnace body (22), a crucible (1) in the furnace body (22), a multi-section heater (2) on a periphery of the crucible (1), a thermal insulation sleeve (3), a crucible support (4), and a main support (11), wherein
the device further comprises a centrifugal motor (14) connected to the main support (11), and the centrifugal motor (14) drives the main support (11), the crucible support (4) and the crucible (1) to rotate;
the crucible (1) is provided with a crucible cover (1-1) at a top end, and a sealing groove (1-2) is formed on an upper portion of the crucible cover (1-1);
the device further comprises a sealing cover (18) that fits the sealing groove (1-2), and the sealing cover (18) is connected to a sealing cover driving device outside the furnace body (22) through an auxiliary rod I (15); a volatile element loader (16) is connected below the sealing cover (18), the volatile element loader (16) is provided with ventilation holes (16-1), and the sealing cover (18), under the action of the driving device, extends the volatile element loader (16) into and out of the crucible (1); and
the device further comprises an auxiliary feeder (17-1) arranged inside the furnace body (22), and the auxiliary feeder (17-1) is connected to an auxiliary feeder driving device outside the furnace body (22) through an auxiliary rod II (17).

2. The device for indium phosphide synthesis and VGF crystal preparation according to claim 1, **characterized in that** the ventilation holes (16-1) are formed around the volatile element loader (16).

3. The device for indium phosphide synthesis and VGF crystal preparation according to claim 1, **characterized in that** the crucible (1) comprises a main crucible (1-3), an auxiliary crucible (1-4) and a seed crystal tank (1-5), with diameters decreasing sequentially.

4. The device for indium phosphide synthesis and VGF crystal preparation according to claim 3, **characterized in that** the auxiliary crucible (1-4) is horn-shaped with a large section and a small section from top to bottom.

5. The device for indium phosphide synthesis and VGF crystal preparation according to claim 3, **characterized in that** the device further comprises a thermocouple hole I (4-1), a thermocouple hole II (4-2), a thermocouple hole III (4-3), a thermocouple hole IV (4-4), and a central thermocouple hole (4-5).

6. The device for indium phosphide synthesis and VGF crystal preparation according to claim 5, **characterized in that**
the thermocouple hole I (4-1) penetrates through the furnace body (22), and a top thereof is close to a lower end of the main crucible (1-3);
the thermocouple hole IV (4-4) penetrates through the furnace body (22), and a top thereof is in a middle of the main crucible (1-3);
the thermocouple hole II (4-2) penetrates through the furnace body (22), the main support (11), and the crucible support (4), and a top thereof is in a middle of the auxiliary crucible (1-4);
the thermocouple hole III (4-3) penetrates through the furnace body (22), the main support (11), and the crucible support (4), and a top thereof is at an upper end of the auxiliary crucible (1-4); and
the central thermocouple hole (4-5) penetrates through the furnace body (22), the main support (11), and the crucible support (4), and a top thereof is at a bottom of the seed crystal tank (1-5).

7. A method for indium phosphide synthesis and VGF crystal preparation, implemented based on the device for indium phosphide synthesis and crystal preparation according to any one of claims 1-6, **characterized by** comprising the following steps:
S1, placing a seed crystal (6) in the seed crystal tank (1-5), and placing metal indium (5) in the main crucible (1-3); placing boron oxide (21) in the auxiliary feeder (17-1); placing red phosphorus (19) in the volatile element loader (16); and separating a second thermocouple (8) and a third thermocouple (9) from the thermocouple hole II (4-2) and the thermocouple hole III (4-3);
the metal indium (5) is in a cylindrical shape, an inner diameter thereof is larger than a diameter of the volatile element loader (16), and an outer diameter thereof is larger than a maximum diameter of the auxiliary crucible (1-4);
putting a sealing material (13) into the sealing groove (1-2);
welding the crucible cover (1-1) to the crucible (1) for integration;
S2, evacuating the furnace body (22) to 100 Pa-10⁻⁵ Pa;
S3, heating the sealing material (13) in the sealing groove (1-2) through the multi-section heater (2) until melting, placing the volatile element loader (16) into the auxiliary crucible (1-4) through the auxiliary rod I (15), and placing the sealing cover (18) on the sealing groove (1-2) simultaneously, to separate the auxiliary rod I (15) from the sealing cover (18); and adjusting the multi-section heater (2) to cool down and solidify the sealing material (13), and sealing the crucible (1) by using the solidified sealing material (13) and the sealing cover (18);
S4, starting the centrifugal motor (14) to drive the main support (11), the crucible support (4) and the crucible (1) to rotate at a speed of 500-5000 rpm;
S5, heating the main crucible (1-3) to 30-200°C above a melting point of indium phosphide using the multi-section heater (2); and simultaneously heating the auxiliary crucible (1-4) to 590°C, gradually increasing the temperature to 650°C, and during the heating process, gradually introducing inert gas into the furnace body (22) until reaching 12.75 MPa;
during this process, the red phosphorus (19) is heated and sublimates into a gas, and the gas is in contact with a large area of an indium melt for synthesis;
S6, after 3-5 h of synthesis, adjusting power of each section of the multi-section heater (2), wherein temperatures of a first thermocouple (7) and a fourth thermocouple (10) drop to 550°C, such that synthesized indium phosphide is solidified into a cylindrical solid, and a temperature of the auxiliary crucible (1-4) drops to below 590°C; and gradually reducing the pressure inside the furnace body (22) to one atmospheric pressure;
reducing a rotational speed of the centrifugal motor (14) to 0;
adjusting the power of the multi-section heater (2) close to a heater in the sealing groove (1-2) to melt the sealing material (13); and connecting the auxiliary rod I (15) and the sealing cover (18), such that the volatile element loader (16) is detached from inside of the crucible (1) and the sealing cover (18) is away from the crucible (1);
S7, pouring the boron oxide (21) in the auxiliary feeder (17-1) into the crucible (1) through the auxiliary rod II (17);
inserting the second thermocouple (8) and the third thermocouple (9) into the thermocouple hole II (4-2) and the thermocouple hole **III** (4-3) respectively;
adjusting the power of each section of the multi-section heater (2), such that the temperature of the central thermocouple (12) is 20-50°C below the melting point of indium phosphide, the temperatures of the first thermocouple (7), the second thermocouple (8), the third thermocouple (9), the fourth thermocouple (10) are 50-200°C above the melting point of indium phosphide, an indium phosphide melt in the crucible (1) has a temperature gradient of 5-50 cm/°C, and the temperature in a direction close to the seed crystal (6) is low;
the cylindrical solid indium phosphide melts into liquid again and flows into the main crucible (1-3) and the auxiliary crucible (1-4); since the temperature at a bottom of the seed crystal (6) is lower than the melting point of indium phosphide, the temperature of synthesized indium phosphide melt is higher than that of indium phosphide; part of the seed crystal (6) melts, and an equilibrium state between the seed crystal (6) and the indium phosphide melt is established;
S8, adjusting the power of each section of the multi-section heater (2) to establish a vertical temperature gradient and achieve single crystal growth of indium phosphide; and after the growth is completed, cooling the system to room temperature, removing the crucible (1) from the crucible support (4), and taking out a crystal (20).

8. The method for indium phosphide synthesis and VGF crystal preparation according to claim 7, **characterized in that** in the step 5, after the indium phosphide (5) is melted, the indium melt is fitted onto a wall of the main crucible (1-3) under the action of a centrifugal force.
